(19)

Europäisches
Patentamt

European
Patent Office

Office européen
des brevets

(11) **EP 3 825 578 A1**

(12) **EUROPEAN PATENT APPLICATION**

(43) Date of publication:
26.05.2021 Bulletin 2021/21

(51) Int Cl.:
*F16H 25/20* (2006.01)    *H01J 37/20* (2006.01)

(21) Application number: 20208673.2

(22) Date of filing: 19.11.2020

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(30) Priority: 25.11.2019   JP 2019212112

(71) Applicant: Jeol Ltd.
Akishima, Tokyo 196-8558 (JP)

(72) Inventors:
• YUASA, Shuichi
  Akishima, Tokyo 196-8558 (JP)
• KOBAYASHI, Masaaki
  Akishima, Tokyo 196-8558 (JP)
• IKEDA, Yuta
  Akishima, Tokyo 196-8558 (JP)

(74) Representative: Boult Wade Tennant LLP
Salisbury Square House
8 Salisbury Square
London EC4Y 8AP (GB)

(54) **ACTUATOR, SAMPLE POSITIONING DEVICE, AND CHARGED PARTICLE BEAM SYSTEM**

(57)    There is provided an actuator capable of reducing drift of an object or body to be driven. The actuator (100) has: a motor section (10); a ball spline (20) having a finite stroke and equipped with a shaft (22) capable of moving along its axis; an external screw thread (34) formed on the shaft (22); a nut section (32) having an internal screw thread (33) engaging the external screw thread (34) and operating to transmit the rotary force of the motor section (10) to the shaft (22); and a case (60) housing the motor section (10) and the ball spline (20).

The shaft (22) has a contact section (70) at its front end, the contact section (70) being designed to make contact with the driven object. The contact section (70) is lower than the shaft (22) in thermal conductivity. Due to heat generated by the motor section (10), the shaft (22) elongates along the axis of the shaft (22) in a first direction (A), and the case (60) elongates along the axis of the shaft (22) in a second direction (B) opposite to the first direction (A).

FIG.1

EP 3 825 578 A1

**Description**

BACKGROUND OF THE INVENTION

1. Field of the Invention

The present invention relates to an actuator, a sample positioning device, and a charged particle beam system.

2. Description of the Related Art

A sample positioning device for an electron microscope is used such that a sample is moved and placed in position. Such a sample positioning device uses an actuator equipped with magnetic motors, the actuator being used to move the sample usualy in the X-axis and Y-axis directions.

For example, patent document 1 discloses an actuator for use in a sample positioning device. This actuator has a motor section, a ball spline of a finite stroke, and a nut section. The ball spline has a shaft provided with rolling grooves which are formed axially. Balls can roll in the rolling grooves. The shaft has an external screw thread. The nut section has an internal screw thread which engages the external screw thread. The nut section acts to transmit the rotating force of the motor section to the shaft.

Citation List

Patent Documents

Patent document 1: JP-A-2016-84919
In the above-described actuator, the shaft is elongated by heat generated by the motor section. Consequently, if the actuator is not operated, the position of the front end of the shaft may deviate, moving the sample.

SUMMARY OF THE INVENTION

One aspect of the actuator of the present invention has:

    a motor section;
    a ball spline having a finite stroke and equipped with a shaft capable of moving along its axis;
    an external screw thread formed on the shaft;
    a nut section having an internal screw thread which engages the external screw thread, the nut section operating to transmit rotary force of the motor section to the shaft; and
    a case to which the motor section and the ball spline are secured.

The case has a fixed portion secured to a supportive member. The shaft elongates from the nut section in a first direction along the axis of the shaft due to heat generated by the motor section. The case elongates from the fixed portion along the axis of the shaft in a second direction opposite to the first direction due to the heat generated by the motor section. The shaft has a contact portion at its front end. The contact portion is designed to make contact with an object or body to be driven. The contact portion is lower in thermal conductivity than the shaft.

In this actuator, the shaft elongates along the axis of the shaft in the first direction from the nut portion due to the heat generated by the motor section. The case elongates in the second direction opposite to the first direction along the axis of the shaft from the fixed portion due to the heat generated by the motor section. Therefore, the displacement of the front end of the shaft caused by the elongation of the shaft due to the heat generated by the motor section can be reduced by the elongation of the case due to the heat generated by the motor section. Consequently, in this actuator, drift of the driven object or body can be reduced.

One aspect of the sample positioning device of the present invention is for use in placing a sample in position within a sample chamber of a charged particle beam system and characterized in that the sample positioning device includes the novel actuator described just above.

Since this sample positioning device includes the novel actuator, mechanical drift of the sample can be reduced.

One aspect of the charged particle beam system of the present invention includes the novel actuator described just above.

Since this charged particle beam system includes the novel actuator, mechanical drift of an object or body to be driven can be reduced.

BRIEF DESCRIPTION OF THE DRAWINGS

    FIG. 1 is a schematic cross-sectional view of an actuator associated with one embodiment of the present invention.
    FIG. 2 is a schematic perspective view of a ball spline of a finite stroke.
    FIG. 3 is a cross-sectional view illustrating elongation of a shaft due to heat generated by a motor section and elongation of a case.
    FIG. 4 is a schematic view of a sample positioning device associated with another embodiment of the invention.
    FIG. 5 is a diagram showing the configuration of an electron microscope associated with a further embodiment of the invention.

DETAILED DESCRIPTION OF THE INVENTION

The preferred embodiments of the present invention are hereinafter described in detail with reference to the drawings. It is to be understood that the embodiments provided below are not intended to unduly restrict the scope and content of the present invention delineated by the appended claims and that not all the configurations described below are essential constituent components of the invention. 1. Actuator

1.1. Configuration of Actuator

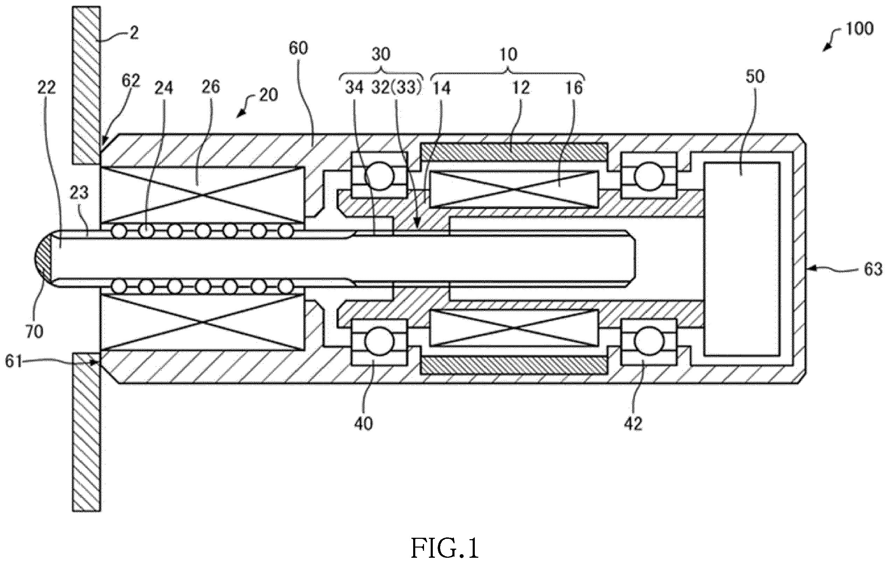

An actuator associated with one embodiment of the present invention is first described by referring to FIG. 1, which is a schematic cross-sectional view of the actuator, 100, associated with the one embodiment. In FIG. 1, a ball spline 20 and an encoder 50 are shown in simplified form.

As shown in FIG. 1, the actuator 100 includes a motor section 10, the ball spline 20, a sliding screw 30, bearings 40, 42, the encoder 50, a case 60, and a contact section 70.

The motor section 10 includes magnets 12, a rotor 14, and a coil 16. The magnets 12 are secured to the inner peripheral surface of the case 60. The magnets 12 are permanent magnets, for example. The rotor 14 is rotatably supported to the case 60 via the bearings 40 and 42. The coil 16 is fastened to the outer peripheral surface of the rotor 14. Electrical current is supplied from a controller (not shown) to the coil 16. In the motor section 10, the rotor 14 is rotated by making use of the force acting on the electrical current through the coil 16 within the magnetic field produced by the magnets 12.

The rotor 14 is made, for example, of an Invar alloy which has a small linear coefficient of expansion. One example of the Invar alloy constituting the material of the rotor 14 is Invar 36, which is an Fe-Ni alloy and contains 36% Ni.

The ball spline 20 includes a shaft 22, balls 24, and a bearing section 26. The ball spline 20 has a finite stroke. That is, the ball spline 20 does not have any circulation path for circulating the balls 24.

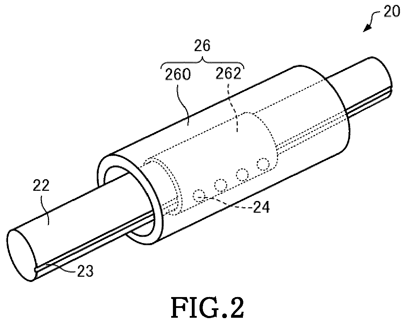

FIG. 2 is a schematic perspective view of the ball spline 20. In the ball spline 20, the shaft 22 acts as a spline shaft. The shaft 22 is the output shaft of the actuator 100. First rolling grooves (spline grooves) 23 along the axis of the shaft 22 are formed in the outer peripheral surface of a front end portion of the shaft 22. The first rolling grooves 23 permit the balls 24 to roll therein. The first rolling grooves 23 are plural in number. No restriction is imposed on the number of the first rolling grooves 23.

The balls 24 can roll in the first rolling grooves 23. The plural balls 24 are disposed in the first rolling grooves 23 and constitute series of balls arrayed axially of the shaft 22.

The bearing section 26 is secured to the case 60 and supports the shaft 22 via the balls 24. The bearing section 26 has an outer cylinder (splined outer cylinder) 260 and a retainer 262. The outer cylinder 260 is held to the inner peripheral surface of the case 60. The outer cylinder 260 is provided with second rolling grooves (not shown) corresponding to the first rolling grooves 23 in the shaft 22. The balls 24 are rollably interposed between the first rolling grooves 23 of the shaft 22 and the second rolling grooves of the outer cylinder 260. The retainer 262 is disposed inside the outer cylinder 260. The balls 24 are held apart from each other by the retainer 262.

In the bearing section 26, the balls 24 are held in this way by the retainer 262 and so the balls 24 do not contact each other. The retainer 262 is of a non-circulation type retainer in which the balls 24 are not circulated. When the shaft 22 makes a linear motion, the retainer 262 also moves. Therefore, the stroke has a finite amount. That is, in the ball spline 20, the balls 24 roll only in the first rolling grooves 23 and do not run in any circulation path. Consequently, the balls 24 are preloaded with a constant force at all times.

The shaft 22, balls 24, and bearing section 26 are made of a metal such as stainless steel, for example. The shaft 22 is supported by the bearing section 26 via the balls 24. By causing the balls 24 to roll in the first rolling grooves 23 formed along the axis of the shaft 22, rotation of the shaft 22 about its axis is suppressed and the shaft 22 moves linearly in the axial direction.

The ball spline 20 is preloaded to eliminate any gaps in the direction of rotation. This allows better suppression of both rotation of the shaft 22 and generation of swinging motion. Accordingly, in the actuator 100, only an axial thrust force can be transmitted to the object to be driven.

Referring back to FIG. 1, the sliding screw 30 is a mechanism for converting the rotary motion of the rotor 14 of the motor section 10 into a linear motion of the shaft 22. The sliding screw 30 functions as a feeding mechanism for taking the output shaft 22 into and out of the actuator 100. As shown in FIG. 1, the sliding screw 30 includes the shaft 22 and a nut section 32.

The shaft 22 has a rear end portion on which an external screw thread 34 is formed. The nut portion 32 is fixed to the rotor 14 of the motor section 10 and has an internal screw thread 33 which engages the external screw thread 34 of the shaft 22. It may also be said that the nut section 32 provides a mechanical part in which the internal screw thread 33 is formed.

As the rotor 14 of the motor section 10 rotates, the nut section 32 also rotates. The internal screw thread 33 of the nut section 32 and the external screw thread 34 of the shaft 22 rotate in threaded engagement with each other. This causes a linear motion of the shaft 22.

The external screw thread 34 of the shaft 22 and the internal screw thread 33 of the nut portion 32 which together constitute the sliding screw 30 are preferably polished because the sliding screw 30 will exhibit a smoother behavior with less vibrations.

The rotor 14 is rotatably supported to the case 60 via the bearings 40 and 42. The bearing 40 supports the front end side of the rotor 14, while the bearing 42 supports the rear end side of the rotor 14. In this example, the rotor 14 is rotatably supported via the two bearings 40 and 42. No restrictions are imposed on the number of the bearings 40, 42 for supporting the rotor 14 or on the manner in which the bearings are preloaded.

The encoder 50 is a sensor for detecting the rotational speed, direction of rotation, angular position, and other factors of the rotor 14 of the motor section 10. The encoder 50 detects these factors and outputs these kinds of information to the controller. The encoder 50 is disposed inside the case 60.

The case 60 accommodates the motor section 10, the ball spline 20, the sliding screw 30, the bearings 40, 42, and the encoder 50. The case 60 closes the magnetic path, for example, in the magnets 12 of the motor section 10, thus forming a magnetic circuit. The motor section 10 and the ball spline 20 are secured to the case 60.

The case 60 is fixedly mounted to the supportive member 2 for supporting the actuator 100. The case 60 has a fixed portion 62 that is designed to be secured to the supportive member 2. The part of the case 60 which is secured to the supportive member 2 constitutes the fixed portion 62. The fixed portion 62 may be screwed to the supportive member 2 or bonded to the supportive member 2 with adhesive or other means.

In the illustrated example, the fixed portion 62 is formed at the front end 61 of the case 60. There is no restriction on the position of the fixed portion 62 as long as it is other than the rear end 63 of the case 60.

The case 60 is made, for example, of an Invar alloy. One example of the Invar alloy used as the material of the case 60 is Invar 36. As an example, the case 60 is made of the same material as that of the rotor 14. Using an Invar alloy as the material of the case 60 can reduce the linear coefficient of expansion of the case 60. Furthermore, the case 60 can constitute a magnetic circuit.

The contact section 70 is formed at the front end of the shaft 22. The contact section 70 is designed to make contact with the object or body to be driven. In the actuator 100, the contact section 70 is formed at the front end of the shaft 22 and, therefore, the shaft 22 does not directly contact the driven object. The contact section 70 is made, for example, of a resin. The contact section 70 is lower in thermal conductivity than the shaft 22. By way of example, the contact section 70 is made of a resin, while the shaft 22 is made of a metal.

1.2. Operation of Actuator

In the actuator 100, if electrical current is supplied from the controller to the coil 16 of the motor section 10, the rotor 14 of the motor section 10 rotates. When the motor section 10 is rotationally driven, the rotary force of the rotor 14 is transformed via the nut section 32 into a thrust force directed axially of the shaft 22. That is, the rotary motion of the motor section 10 is transformed into a linear motion by the sliding screw 30 consisting of the nut section 32 and the shaft 22. Rotation of the shaft 22 about its axis is suppressed by the ball spline 20 and so the shaft 22 makes a linear motion. Consequently, the shaft 22, i.e., the output shaft of the actuator 100, transmits the thrust force directed axially of the shaft 22 to the object to be driven.

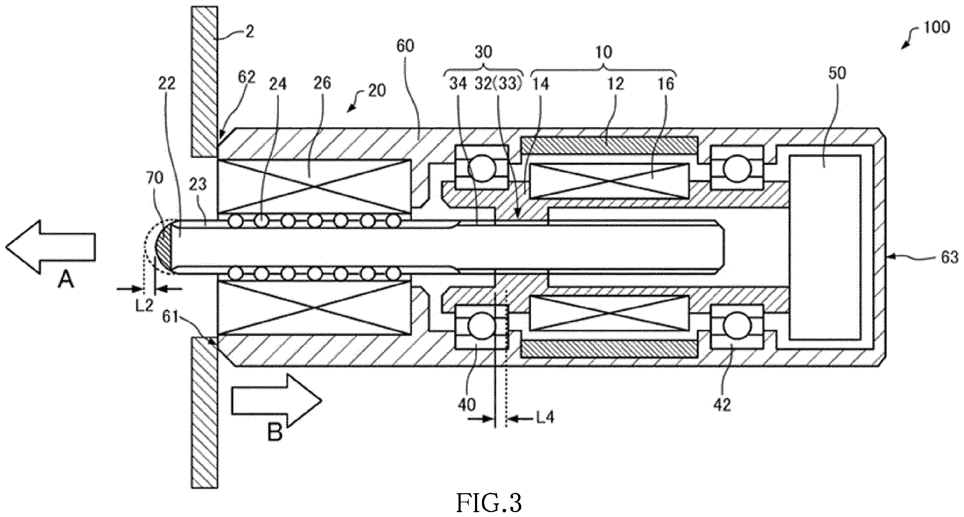

FIG. 3 is a cross-sectional view illustrating elongation of the shaft 22 due to heat generated by the motor section 10 and elongation of the case 60. When electrical current is supplied to the coil 16 of the motor section 10, the coil 16 produces heat. The resulting heat elongates the shaft 22 along its axis from the nut portion 32 in a first direction A, which is directed from the nut section 32 to the front end of the shaft 22. Because the nut section 32 supports the shaft 22, the portion of the shaft 22 supported by the nut section 32 is the fixed end of the shaft 22. Therefore, the shaft 22 elongates from the nut section 32 in the first direction A due to the heat generated by the motor section 10.

Furthermore, due to the heat generated by the motor section 10, the case 60 elongates from the fixed portion 62 in a second direction B along the axis of the shaft 22. The second direction B is opposite to the first direction A and directed from the fixed portion 62 of the case 60 toward the rear end 63 of the case 60. The fixed portion 62 of the case 60 is the fixed end of the case 60. Therefore, due to the heat generated by the motor section 10, the case 60 elongates from the fixed portion 62 in the second direction B. Because of this elongation of the case 60 in the second direction B, the shaft 22 moves in the second direction B.

The amount of elongation L2 of the shaft 22 in the first direction A due to heat generated by the motor section 10 is equal to the amount of movement L4 of the shaft 22 in the second direction B due to the elongation of the case 60 in the second direction B that is caused by the heat generated by the motor section 10. Accordingly, in the actuator 100, the difference between the amount of elongation L2 of the shaft 22 and the amount of movement L4 of the shaft 22 caused by the elongation of the case 60 becomes null. Thus, the elongation of the shaft 22 can be canceled out by the elongation of the case 60. Consequently, the displacement of the position of the front end of the shaft 22 due to the heat generated by the motor section 10 can be reduced.

Note that the difference between the amount of elongation L2 of the shaft 22 in the first direction A and the amount of movement L4 of the shaft 22 due to the elongation of the case 60 may not be zero. The requirement is only that the difference is within a range tolerated by the drift of the object to be driven.

In the actuator 100, the displacement of the position of the front end of the shaft 22 can be reduced as described above by optimizing the position of the fixed portion 62 of the case 60 and the linear coefficients of expansion of the various parts of the actuator 100.

The amount of elongation $\Delta L$ of an object caused by a temperature variation is given by

$$\Delta L = \alpha \times L \times \Delta T$$

where $\alpha$ is the linear coefficient of expansion of the object, L is the original length of the object, and $\Delta T$ is the amount of variation of the temperature of the object.

The linear coefficient of expansion of the case 60 and the linear coefficient of expansion of the shaft 22 are determined while taking account of, for example, the length of the shaft 22 (taken from the fixed end), the length of the case 60 (taken from the fixed end), the heat applied to the shaft 22 from the motor section 10, and the heat applied to the case 60 from the motor section 10. As a consequence, the displacement of the front end of the shaft 22 caused by the elongation of the shaft 22 can be reduced by the elongation of the case 60. For example, the displacement of the front end of the shaft 22 due to the elongation of the shaft 22 is reduced by elongation of the case 60 by making the linear coefficient of expansion of the case 60 smaller than that of the shaft 22. In particular, the case 60 is made of Invar 36 having a low linear coefficient of expansion, while the shaft 22 is made of a stainless steel that is higher than the Invar alloy in linear coefficient of expansion. The combination of the material of the case 60 and the material of the shaft 22 is not restricted to this example.

In the example shown in FIG. 3, the fixed portion 62 of the case 60 is the front end 61 of the case 60. The elongation of the case 60 may be adjusted by varying the position of the fixed portion 62 of the case 60.

In the above-described method, the elongation of the shaft 22 is canceled out by the elongation of the case 60. Alternatively, the elongation of the shaft 22 may be canceled out by the sum of the elongation of the case 60 and the elongation of other member of the actuator 100. For example, the elongation of the shaft 22 may be canceled out by the sum of the elongation of the case 60 and the elongation of the rotor 14.

1.3. Effects

The actuator 100 includes the motor section 10, the ball spline 20 of a finite stroke equipped with the shaft 22 having the first rolling grooves 23 therein, and the nut section 32 having the internal screw thread 33 engaging the external screw thread 34 formed on the shaft 22, the nut section 32 acting to transmit the rotary force of the motor section 10 to the shaft 22. In this way, in the actuator 100, when the output shaft is made to go in or out, only the thrust force directed in the axial direction of the shaft 22 can be transmitted to the object to be driven by using the shaft 22 of the ball spline 20 as the output shaft.

The actuator 100 uses the ball spline 20 of a finite stroke. That is, the ball spline 20 does not have any circulation path for the balls 24. The preload on the balls can be made constant; otherwise vibrations would be produced. Accordingly, in the actuator 100, during operation, vibrations of the shaft 22 can be reduced. Consequently, when a thrust force is applied to the driven object, reduced vibrations occur. The thrust force can be applied, for example, without the driven object vibrating.

For example, where the ball spline is an infinite circulation type ball spline equipped with a ball circulation path, when the balls move between the circulation path and the rolling groove, the preload applied to the balls varies, so that the shaft may vibrate. On the other hand, in the actuator 100, the preload applied to the balls 24 can be kept constant because any circulation path for the balls 24 is not present as described above. Hence, vibrations of the shaft 22 can be reduced.

Furthermore, in the actuator 100, the sliding screw 30 is used as a mechanism to convert the rotary force of the motor section 10 into a thrust force. The sliding screw 30 provides higher rigidity and a lower power transmission efficiency, for example, than a case where a ball screw for converting the rotary force of the motor section into a thrust force by allowing balls to circulate in a helical rolling groove formed in a ball screw shaft. Ball screws have power transmission efficiencies of, for example, more than 90%. Therefore, in the actuator 100, minute rotations caused by magnetic hysteresis of the motor section 10 and minute vibrations induced by unintentional excitation of the motor section 10 due to servo noise in the controller that controls the motor section 10 can be suppressed from being directly transmitted to the shaft 22.

The servo noise referred to herein is to vibrate the motor section quite minutely by unintentionally exciting or resonating the coil because ripple noises from the power supply or converter or the operating frequency component of the control circuit undesirably enters the power line of the actuator or encoder control line in spite of the absence of positional deviations and the completion of the settling process under control.

In the actuator 100, the rotary force of the motor section 10 is transformed into an axial thrust force by the sliding screw 30 capable of providing a reduced feeding pitch (lead) as compared with a ball screw and, therefore, quite small movements (e.g., on the order of Angstroms) can be achieved over the whole range of the stroke of the shaft 22. Furthermore, in the actuator 100, the driven object can be moved over longer distances than where a thrust force is applied to the driven object, for example, using piezoelectric devices. In addition, it is difficult to cause the process of expansion and contraction of such piezoelectric devices to respond linearly with respect to time and thus it takes a long time for them to settle into their steady states. In the actuator 100, the rotary force of the motor section 10 is transmitted via the nut section 32 and the shaft 22 and so higher rigidity can be afforded amd the settling time can be shortened.

The actuator 100 does not need any reduction gearing. Therefore, the actuator 100 suffers neither from a dead zone due to backlash intrinsic to such reduction gearing nor from unstable operation caused by hysteresis of various members. When driven in minimum or near minimum increments, the operation of the actuator 100 can be stabilized.

In the ball spline 20 of the actuator 100, the balls 24 roll only in the first rolling grooves 23. In particular, the ball spline 20 does not have any circulation path for circulating the balls 24 but can preload the balls with a constant force. Accordingly, in the actuator 100, as noted above, vibrations that would be produced by variations in the preload on the balls 24 can be prevented. Thus, in the actuator 100, during operation, vibrations of the shaft 22 can be reduced. This makes it possible to reduce vibrations produced when a thrust force is applied to the driven object. For example, the thrust force can be applied without causing vibrations of the driven object.

In the actuator 100, the shaft 22 elongates in the first direction A along the axis of the shaft 22 due to the heat generated by the motor section 10. The case 60 elongates in the second direction B opposite to the first direction A along the axis of the shaft 22 due to the heat generated by the motor section 10. Therefore, in the actuator 100, displacement of the front end of the shaft 22 caused by the elongation of the shaft 22 due to the heat generated by the motor section 10 can be reduced by the elongation of the case 60 due to the heat generated by the motor section 10. Consequently, in the actuator 100, drift of the driven object can be reduced.

The actuator 100 has the contact section 70 at the front end of the shaft 22. The contact section 70 is lower in thermal conductivity than the shaft 22. Therefore, the heat of the shaft 22 can be transferred less rapidly to the driven object. In consequence, variations in the temperature of the shaft 22 caused by transfer of heat of the shaft 22 to the driven object can be reduced. As a result, the difference between temperature variations in the shaft 22 and temperature variations in the case 60 can be decreased. For this reason, the process of canceling the elongation of the shaft 22 by the elongation of the case 60 is still applicable. In the actuator 100, therefore, drift of the driven object can be reduced.

Where the driven object is made of a metal having a high thermal conductivity, for example, if the front end of the shaft 22 is in direct contact with the driven object, heat of the shaft 22 escapes to the driven object, so that the shaft 22 becomes lower in temperature than the case 60. As a result, the process of canceling the elongation of the shaft 22 by the elongation of the case 60 is no longer applicable, whereby the position of the front end of the shaft 22 will deviate.

On the other hand, when the contact section 70 is formed at the front end of the shaft 22, the difference between temperature variations in the shaft 22 and temperature variations in the case 60 can be made lower than where the front end of the shaft 22 is in direct contact with the driven object. Accordingly, the process of canceling the elongation of the shaft 22 by the elongation of the case 60 is still applicable.

In this way, the contact section 70 having a thermal conductivity lower than that of the shaft 22 is formed at the front end of the shaft 22. This reduces the amount of heat escaping from the shaft 22 to the driven object, irrespective of the material, i.e., thermal conductivity, of the driven object. Therefore, as described above, the process of canceling the elongation of the shaft 22 by the elongation of the case 60 is applicable and hence drift of the driven object can be reduced.

In the actuator 100, the amount of elongation L2 of the shaft 22 in the first direction A due to heat generated by the motor section 10 is equal to the amount of movement L4 of the shaft 22 in the second direction B due to the elongation of the case 60 in the second direction B caused by the heat generated by the motor section 10. Therefore, in the actuator 100, the elongation of the shaft 22 can be canceled out by the elongation of the case 60. This can reduce the displacement of the position of the front end of the shaft 22 due to the heat generated by the motor section 10. As a result, drift of the driven object can be reduced.

In the actuator 100, the case 60 makes up a magnetic circuit for the motor section 10 and is made of an Invar alloy. Therefore, the actuator 100 can constitute a magnetic circuit while suppressing the elongation of the case 60 due to heat generated by the motor section 10.

In the actuator 100, the rotor 14 is made of an Invar alloy and, therefore, in the actuator 100, the elongation of the rotor 14 due to heat generated by the motor section 10 can be suppressed.

2. Sample Positioning Device

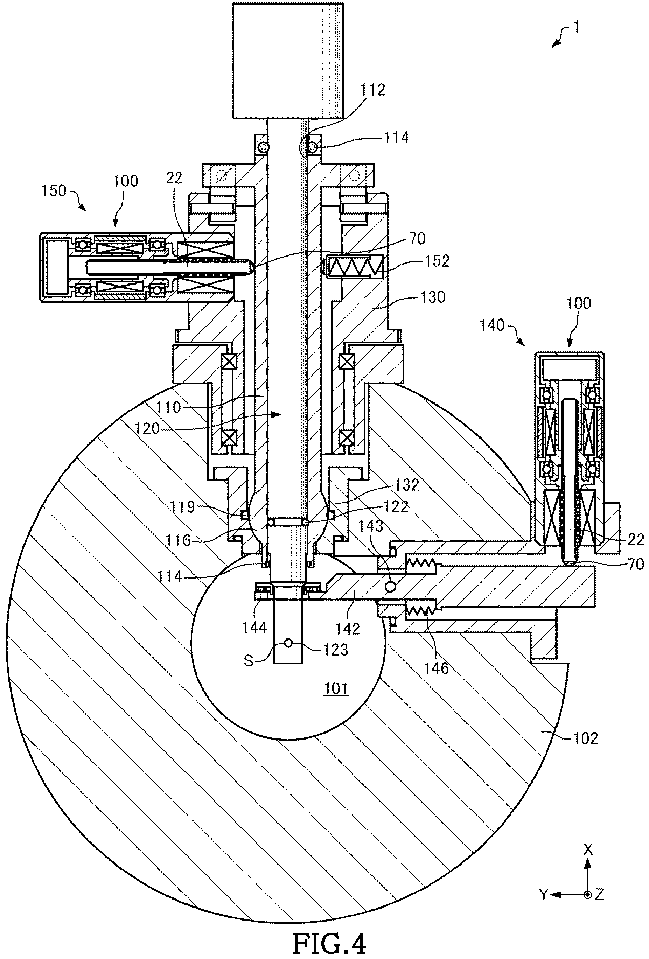

A sample positioning device associated with another embodiment of the present invention is next described by referring to FIG. 4, which schematically shows the sample positioning device, 1, associated with this embodiment. FIG. 4 shows an operational state in which a sample holder 120 is mounted on a shifter 110. In FIG. 4, there are shown X-, Y-, and Z-axes which are three mutually orthogonal axes. Usage states of the sample positioning device 1 are described below. In the illustrated example, the sample positioning device 1 is for use with a transmission electron microscope (TEM).

As shown in FIG. 4, the sample positioning device 1 includes the shifter 110, the sample holder 120, a shifter supporting member 130, an X drive mechanism 140, and a Y drive mechanism 150.

The sample positioning device 1 can move a sample S into a desired position in a sample chamber 101 and bring the sample to a stop there. Specifically, the sample positioning device 1 can support the sample S by the sample holder 120 and move the sample S linearly in the X-axis and Y-axis directions by the drive mechanisms 140, 150. Also, the sample positioning device 1 may move the sample S linearly in the Z-axis direction by a Z drive mechanism (not shown), and may tilt the sample S about the X-axis by a tilt mechanism (not shown). In the illustrated example, the Z-axis direction is the direction of travel of an electron beam (not shown) passing through the sample chamber 101.

In the sample positioning device 1, the shifter 110 is supported by the shifter supporting member 130 provided to extend through a wall portion 102. The shifter 110 has a hole 112 in communication with the sample chamber 101. The sample holder 120 is so mounted as to be movable into this hole 112. The sample holder 120 has a front end portion on which the sample S is placed, the front end portion being disposed in the sample chamber 101. The X drive mechanism 140 moves the sample S in the X-axis direction by moving the sample holder 120. The Y drive mechanism 150 moves the sample S in the Y-axis direction by rotating the shifter 110.

Various members of the sample positioning device 1 are described below. The sample chamber 101 can be maintained in a depressurized state by evacuating the sample chamber 101 by a well-known pump (not shown). The sample S is entered into the sample chamber 101 by the sample holder 120. In the sample chamber 101, the sample S is illuminated with an electron beam.

The shifter supporting member 130 is a cylindrical member extending through the wall portion 102. The shifter 110 is inserted in the shifter supporting member 130. A spherical bearing portion 132 is mounted on the sample chamber (101) side of the shifter supporting member 130 and has a spherical inner surface.

The shifter 110 is a tubular member and has the hole 112 in communication with the sample chamber 101. In the illustrated example, the hole 112 extends in the X-axis direction. The sample holder 120 is mounted in the hole 112. Thus, movements of the sample holder 120 in the Y-axis and Z-axis directions are restricted and the sample holder 120 can move linearly in the X-axis direction. Bearings 114 supporting the sample holder 120 are mounted inside the shifter 110. In the illustrated example, the bearings 114 are mounted at both ends of the shifter 110, i.e., in the vicinity of the opening of the hole 112. The bearings 114 can smoothen movement of the sample holder 120 in the X-axis direction.

The shifter 110 has a spherical portion 116 at the end on the sample chamber (101) side. The surface of the spherical portion 116 is formed like a sphere centered on the center axis of the hole 112. The spherical portion 116 is supported by the spherical bearing portion 132 whose inner surface is formed in contact with the surface of the spherical portion 116. Consequently, the spherical portion 116 is slidably supported to the spherical bearing portion 132. Thus, the shifter 110 can rotate about the center of the spherical portion 116. An O-ring 119 is mounted between the spherical portion 116 and the spherical bearing portion 132 to hermetically seal the sample chamber 101.

The sample holder 120 is movably mounted in the hole 112 of the shifter 110. The sample holder 120 has a front end portion provided with a sample holding portion 123 for holding the sample S. The O-ring 122 is mounted on the sample holder 120 to hermetically seal between the sample holder 120 and the shifter 110. As the sample holder 120 moves, the O-ring 122 slides in the hole 112 of the shifter 110.

The drive mechanisms 140 and 150 can vary the position of the sample holder 120 in the sample chamber 101. Specifically, the drive mechanisms 140 and 150 operate the sample holder 120 to move the sample S into position within the sample chamber 101 and to bring the sample to a stop at that position.

The X drive mechanism 140 includes the actuator 100 and a lever 142 and operates to move the sample S in the X-axis direction. The lever 142 is a mechanical lever that can rotate about an axis 143. The bearings 144 are mounted at the end of the lever 142 on the sample chamber (101) side. The sample holder 120 is supported via the bearings 144 capable of rolling within the Y-Z plane. This can smoothen movement of the sample S in the Y-axis direction. Since a force directed in the negative X-axis direction acts on the sample holder 120, the holder 120 is pushed against the lever 142 (i.e., the bearings 144). The contact section 70 of the actuator 100 is in contact with the end of the lever 142 on the opposite side of the sample chamber 101.

The actuator 100 moves the shaft 22 linearly in the X-axis direction, causing the lever 142 to rotate about the axis 143. This moves the sample holder 120 (and the sample S) linearly in the X-axis direction. A bellows 146 can smoothen movement of the lever 142 while retaining the sample chamber 101 in a depressurized state.

The Y drive mechanism 150 moves the sample S in the Y-axis direction and includes the actuator 100. Furthermore, the Y drive mechanism 150 includes a return spring 152. The contact section 70 of the actuator 100 is in contact with the front outer peripheral surface of the shifter 110 as viewed in the Y-axis direction. The return spring 152 is mounted on the rear outer peripheral surface of the shifter 110 as viewed in the Y-axis direction. The shifter 110 is biased in the positive Y-axis direction by the return spring 152. When the actuator 100 moves the shaft 22 linearly in the Y-axis direction, the shifter 110 rotates about the center of the spherical portion 116. Consequently, the sample S can be moved linearly in the Y-axis direction.

The sample positioning device 1 may further include a Z drive mechanism (not shown) for moving the sample S in the Z-axis direction. The Z drive mechanism may be similar in configuration to the Y drive mechanism 150. In addition, the sample positioning device 1 may have a tilt mechanism (not shown) for tilting the sample S about the X-axis.

The operation of the sample positioning device 1 is next described. In the sample positioning device 1, the sample S is moved in the X-axis direction by moving the sample holder 120 in the X-axis direction by means of the X drive mechanism 140. In particular, the lever 142 is rotated by causing the shaft 22 of the actuator 100 constituting the X drive mechanism 140 to go in and out. This moves the sample holder 120 linearly in the X-axis direction, whereby the sample S moves in the X-axis direction.

Furthermore, in the sample positioning device 1, the shifter 110 is moved by the Y drive mechanism 150 to thereby move the sample holder 120. This moves the sample S in the Y-axis direction. In particular, the shifter 110 is rotated about the center of the spherical portion 116 by making the shaft 22 of the actuator 100 constituting the Y drive mechanism 150 go in and out. Concomitantly with the rotation of the shifter 110, the sample holder 120 rotates, thus moving the sample S in the Y-axis direction.

The sample positioning device 1 has the following advantages. The sample positioning device 1 includes the actuator 100 which can reduce vibrations of the shaft 22 during operation of the actuator 100 as described above. Therefore, the sample positioning device 1 can reduce vibrations of the sample S when it is moved. Consequently, the sample positioning device 1 permits a user to observe the sample S with high magnification while moving the sample S in the X-axis or Y-axis direction.

Furthermore, since the sample positioning device 1 includes the actuator 100, ultramicroscopic motions (such as on the order of Angstroms) can be made over the whole stroke of the shaft 22 as described above. The driven object can be moved over a greater range of distance as compared to the case where a thrust force is applied to the driven object, for example, using piezoelectric devices. Accordingly, with the sample positioning device 1, ultramicroscopic motions such as on the order of Angstroms can be made over the whole length of the sample S having a diameter of, for example, 2 mm. In consequence, drift correction can be made over the whole length of the sample S.

Accordingly, the sample positioning device 1 can prevent out-of-stroke drift correction (i.e., deviating from the drift correctable range) in various analyses including elemental mapping, spectral analysis, and atomic analysis needing long-time drift correction, and also in heating, cooling, tomography, and other in situ observations which require drift correction over a long distance.

Additionally, since the sample positioning device 1 includes the actuator 100, the settling time can be shortened as compared to the case where a thrust force is applied to the driven object, for example, using piezoelectric devices as mentioned above and so it is possible to promote settling of the drift of the sample S.

Further, in the sample positioning device 1, the contact section 70 of the actuator 100 is in contact with the lever 142 and so the heat of the shaft 22 can be transmitted to the lever 142 less readily. As a result, drift of the sample can be reduced as described above.

Also, in the sample positioning device 1, the contact section 70 of the actuator 100 is in contact with the shifter 110 and so the heat of the shaft 22 can be conducted to the shifter 110 less readily. As a result, drift of the sample can be reduced as described above.

3. Electron Microscope

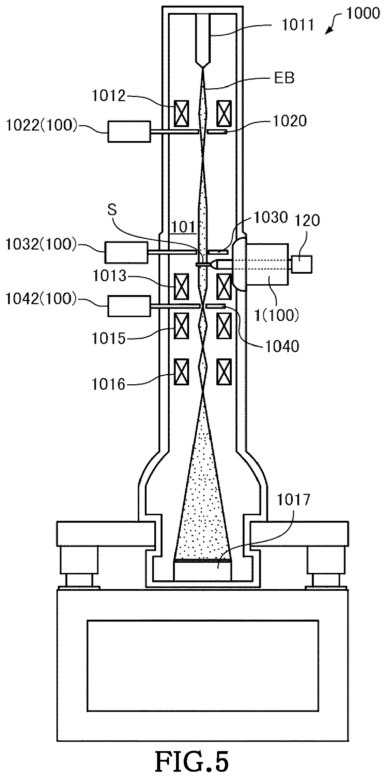

An electron microscope associated with a further embodiment of the present invention is next described by referring to FIG. 5, which shows the configuration of the electron microscope, 1000, associated with this embodiment. FIG. 5 shows an operational state in which a sample S has been introduced in a sample chamber 101.

The electron microscope 1000 has the configuration of a transmission electron microscope (TEM), for example, and includes the sample positioning device 1. The electron microscope 1000 further includes an electron beam source 1011, condenser lenses 1012, an objective lens 1013, an intermediate lens 1015, a projector lens 1016, an imager section 1017, a condenser aperture 1020, a condenser aperture positioning device 1022, an objective aperture 1030, an objective aperture positioning device 1032, a selected area aperture 1040, and a selected area aperture positioning device 1042.

The electron beam source 1011 emits an electron beam EB which is focused and directed at the sample S by the condenser lenses 1012. The objective lens 1013 is an initial stage of lens for bringing the electron beam EB transmitted through the sample S into focus.

The sample positioning device 1 places the sample S held on the sample holder 120 in position in the sample chamber 101 as described previously. The sample positioning device 1 can move the sample S in the horizontal direction perpendicular to the direction of travel of the electron beam EB by the drive mechanisms 140 and 150 each equipped with the actuator 100.

The intermediate lens 1015 and the projector lens 1016 cooperate to further magnify the image focused by the objective lens 1013 and to focus the magnified image onto the imager section 1017. In the electron microscope 1000, an imaging system is comprised of the objective lens 1013, intermediate lens 1015, and projector lens 1016.

The imager section 1017 captures a TEM (transmission electron microscopy) image focused by the imaging system. For example, the imager section 1017 is a digital camera such as a CCD or CMOS camera.

The condenser aperture 1020 is positioned, for example, between the assembly of the condenser lenses 1012 and the objective lens 1013. For example, the condenser aperture 1020 can adjust the angular aperture and dose of the electron beam EB made to impinge on the sample S. The condenser aperture 1020 is a movable aperture plate capable of selecting an aperture-hole diameter and making a positional adjustment from outside the vacuum.

The condenser aperture positioning device 1022 moves the condenser aperture 1020 to select an aperture-hole diameter or make a positional adjustment. The condenser aperture positioning device 1022 is equipped with the actuator 100 as a drive source. Consequently, the condenser aperture 1020 can be moved minutely without vibrations. Thus, the condenser aperture 1020 can be accurately placed in position. In addition, after the condenser aperture 1020 is moved, for example, the resulting drift can be settled more rapidly.

The objective aperture 1030 is located in the back focal plane of the objective lens 1013. The objective aperture 1030 is used to accept transmitted waves and diffracted waves for obtaining bright field and dark field images. The objective aperture 1030 is a movable aperture plate capable of selecting an aperture-hole diameter and making a positional adjustment from outside the vacuum.

The objective aperture positioning device 1032 is used to move the objective aperture 1030 for selecting an aperture-hole diameter or making a positional adjustment. The objective aperture positioning device 1032 is equipped with the actuator 100 as a drive source. Consequently, the objective aperture 1030 can be moved minutely without vibrations. Thus, the objective aperture 1030 can be accurately placed in position. Furthermore, after the objective aperture 1030 is moved, for example, settling of the resulting drift can be hastened.

The selected area aperture 1040 is disposed in the image plane of the objective lens 1013, i.e., in the object plane of the intermediate lens 1015. When selected-area diffraction is performed, the selected area aperture 1040 limits the area of the sample S from which a diffraction pattern is derived. The selected area aperture 1040 is a movable aperture plate capable of selecting an aperture-hole diameter and making a positional adjustment from outside the vacuum.

The selected area aperture positioning device 1042 is used to move the selected area aperture 1040 to select an aperture-hole diameter or make a positional adjustment. The selected area aperture positioning device 1042 is equipped with the actuator 1000 as a drive source. Consequently, the selected area aperture 1040 can be moved minutely without vibrations. This makes it possible to place the selected area aperture 1040 in position accurately. Furthermore, after the selected area aperture 1040 has been moved, for example, settling of the resulting drift can be hastened.

4. Modifications

It is to be understood that the present invention is not restricted to the foregoing embodiments and that the invention can be practiced in variously modified forms without departing from the scope of the present invention as defined by the claims.

For example, in the above embodiment illustrated in FIG. 1, the motor section 10 of the actuator 100 has the magnets 12, rotor 14, and coil 16. The configuration of the motor section 10 is not restricted to this example. The motor section 10 may be a magnetic motor such as an AC servomotor, DC servomotor, or stepping motor. That is, the actuator 100 can be applied to a linear actuator for converting the rotary force of the magnetic motor section 10 into a thrust force.

For example, in the above-described embodiment illustrated in FIG. 4, the actuator 100 is applied to the sample positioning device 1 for an electron microscope. In the embodiment described in connection with FIG. 5, the actuator 100 is applied to the aperture positioning devices 1022, 1032, and 1042. Alternatively, the actuator 100 may be used as a detector positioning device (such as an EDS detector, a dark field detector, or the like) for use in an electron microscope to move and place the detector into position.

Furthermore, in the above-described embodiments, the sample positioning device 1 is applied to a transmission electron microscope (TEM). The positioning device 1 may be applied to other charged particle beam systems, as well as to TEMs. Examples of such charged particle beam systems include electron microscopes (e.g., scanning electron microscopes (SEM) and scanning transmission electron microscopes (STEM)), focused ion beam (FIB) systems, and electron beam exposure systems.

It is to be noted that the above-described embodiments and modifications are merely exemplary and that the present invention is not restricted to them. For example, the embodiments and modifications may be combined appropriately.

The present invention embraces configurations (e.g., configurations identical in function and method) which are substantially identical to the configurations described in any one of the above embodiments. Furthermore, the invention embraces configurations which are similar to the configurations described in any one of the above embodiments except that their nonessential portions have been replaced. Further, the invention embraces configurations which are similar to the configurations described in any one of the above embodiments except that a well-known technique is added.

**Claims**

1. An actuator comprising:

   a motor section;
   a ball spline having a finite stroke and equipped with a shaft capable of moving along its axis, the shaft having a contact portion at its front end, the contact portion being designed to make contact with an object or body to be driven, the contact portion is lower in thermal conductivity than the shaft;
   an external screw thread formed on the shaft;
   a nut section having an internal screw thread which engages the external screw thread, the nut section operating to transmit rotary force of the motor section to the shaft; and
   a case to which the motor section and the ball spline are secured, the case having a fixed portion fixed to a supportive member;
wherein the shaft elongates from the nut section in a first direction along the axis of the shaft due to heat generated by the motor section; and
wherein the case elongates from the fixed portion along the axis of the shaft in a second direction opposite to the first direction due to the heat generated by the motor section.

2. An actuator as set forth in claim 1, wherein said case forms a magnetic circuit and is made of an Invar alloy.

3. An actuator as set forth in any one of claims 1 and 2, wherein said shaft is made of a metal, and wherein said contact portion is made of a resin.

4. An actuator as set forth in any one of claims 1 to 3, wherein an amount of elongation of said shaft in said first direction due to the heat generated by said motor section and an amount of movement of said shaft in said second direction caused by the elongation of the case in the second direction due to the heat generated by the motor section are equal to each other.

5. An actuator as set forth in any one of claims 1 to 4, wherein said ball spline has:

   an outer cylinder;
   a plurality of balls rollably mounted between first rolling grooves formed in said shaft along said axis and second rolling grooves formed in the outer cylinder along said axis; and
   a retainer by which the balls are kept apart from each other along the first and second rolling grooves, the retainer moving concomitantly with movement of the shaft.

6. A sample positioning device for placing a sample in position within a sample chamber of a charged particle beam system, said sample positioning device includes an actuator as set forth in any one of claims 1 to 5.

7. A charged particle beam system including an actuator as set forth in any one of claims 1 to 5.

FIG.1

FIG.2

FIG.3

FIG.4

FIG.5

Europäisches
Patentamt

European
Patent Office

Office européen
des brevets

## EUROPEAN SEARCH REPORT

Application Number

EP 20 20 8673

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/186844 A1 (YUASA SHUICHI [JP]) 30 June 2016 (2016-06-30) | 1-3,5-7 | INV. F16H25/20 H01J37/20 |
| A | * the whole document * | 4 | |
| A | DE 44 12 403 A1 (THK CO LTD [JP]) 13 October 1994 (1994-10-13) * the whole document * | 1-5 | |
| A | EP 2 741 311 A2 (JEOL LTD [JP]) 11 June 2014 (2014-06-11) * the whole document * | 1,6,7 | |
| A | JP H01 311845 A (MATSUSHITA ELECTRIC IND CO LTD) 15 December 1989 (1989-12-15) * the whole document * | 1 | |
| A | JP S62 278360 A (HITACHI SEIKO KK) 3 December 1987 (1987-12-03) * the whole document * | 1 | |

| | | | TECHNICAL FIELDS SEARCHED (IPC) |
|---|---|---|---|
| | | | F16H H01J |

The present search report has been drawn up for all claims

| Place of search | Date of completion of the search | Examiner |
|---|---|---|
| Munich | 14 April 2021 | Masset, Candie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 825 578 A1**

## ANNEX TO THE EUROPEAN SEARCH REPORT
## ON EUROPEAN PATENT APPLICATION NO.

EP 20 20 8673

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2021

| Patent document cited in search report | | Publication date | Patent family member(s) | | Publication date |
|---|---|---|---|---|---|
| US 2016186844 | A1 | 30-06-2016 | JP | 6454129 B2 | 16-01-2019 |
| | | | JP | 2016084919 A | 19-05-2016 |
| | | | US | 2016186844 A1 | 30-06-2016 |
| DE 4412403 | A1 | 13-10-1994 | DE | 4412403 A1 | 13-10-1994 |
| | | | JP | H06300106 A | 28-10-1994 |
| | | | US | 5554899 A | 10-09-1996 |
| EP 2741311 | A2 | 11-06-2014 | EP | 2741311 A2 | 11-06-2014 |
| | | | JP | 6054728 B2 | 27-12-2016 |
| | | | JP | 2014116185 A | 26-06-2014 |
| | | | US | 2014158907 A1 | 12-06-2014 |
| JP H01311845 | A | 15-12-1989 | NONE | | |
| JP S62278360 | A | 03-12-1987 | JP | 2698069 B2 | 19-01-1998 |
| | | | JP | S62278360 A | 03-12-1987 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016084919 A